# EUROPÄISCHE PATENTSCHRIFT

(11) **EP 0 642 094 B1**
(45) Veröffentlichungstag und Bekanntmachung des Hinweises auf die Patenterteilung: **02.09.1998**
(21) Anmeldenummer: 94116917.9
(22) Anmeldetag: 14.11.1991
(51) Int. Cl.: G06F 17/50, G05B 19/045

(54) **Programmierverfahren für einen Logikbaustein**
Method for programming a logic unit
Méthode de programmation d'un module logique

(30) Priorität: 22.02.1991 DE 4105678
(43) Veröffentlichungstag der Anmeldung: 08.03.1995
(62) Teilanmeldung aus: 91119483.5
(73) Patentinhaber: SIEMENS AKTIENGESELLSCHAFT, 80333 München (DE)
(72) Erfinder: Bock, Günther, Dipl.-Ing., D-92224 Amberg (DE); Macht, Helmut, Dipl.-Ing., D-92245 Kümmersbruck (DE); Wombacher, Christof, Dipl.-Ing. (FH), D-92224 Amberg (DE); Prechtl, Manfred, Dipl.-Ing., D-92507 Nabburg (DE); Lengemann, Andre, Dipl.-Ing. (FH), D-92265 Edelsfeld (DE)

(56) Entgegenhaltungen:
- EP-A- 0 338 077
- EP-A- 0 380 456
- EP-A- 0 489 228
- ELECTRO CONFERENCE RECORD, Bd.15, 9. Mai 1990, LOS ANGELES US Seiten 353 - 361 AGRAWAL 'field programmable gate arrays (fpgas) provide asic system designers control of their design destiny'
- ELECTRONIC DESIGN., Bd.38, Nr.17, 13. September 1990, HASBROUCK HEIGHTS, NEW JERSEY US Seiten 65 - 71 KNAPP 'accelerate fpga macros with one-hot approach'
- Book no. 9, MäRZ 1990, 'HALBLEITER-SCHALTUNGSTECHNIK', U. TIETZE, CH. SCHENK SPRINGER VERLAG, BERLIN, DE
- Book no. 1, 1989, 'SPEICHERPROGRAMMIERBARE STEUERUNG IN DER AUTOMATISIERUNGSTECHNIK', P. WRATIL VOGEL VERLAG, WüRZBURG

## Beschreibung

Die Erfindung betrifft ein Verfahren zum rechnergesteuerten internen elektrischen Verbinden eines umfeldprogrammierbaren Logikfeldes.

Früher wurden Maschinensteuerungen in Schutz-Technik aufgebaut. Schutz-Schaltungen arbeiten zwar parallel und sind daher schnell, sie sind jedoch störanfällig, kompliziert und nur umständlich aufzubauen bzw. anzupassen. Inzwischen sind speicherprogrammierbare Steuerungen weit verbreitet. Sie arbeiten sequentiell und sind erheblich einfacher aufgebaut und zu programmieren. Aber auch moderne speicherprogrammierbare Steuerungen sind wegen ihrer sequentiellen Arbeitsweise oftmals nicht schnell genug, z.B. für die Steuerung von Verpackungs- oder Etikettiermaschinen. Steuerungen für diese Maschinen werden in der Regel auch heute noch auf der Basis zu verdrahtender Logikelemente aufgebaut. Dadurch bieten diese Steuerungen zwar eine hohe Verarbeitungsgeschwindigkeit, jedoch ist das Verdrahten der Logikelemente sehr umständlich und fehlerträchtig.

Aus der EP-A-0 338 077 ist eine speicherprogrammierbare Steuerung, deren logische Operation mit einem EPROM durchgeführt werden, bekannt, wobei darauf hingewiesen ist, daß anstelle des EPROMS auch ein programmierbarer Logikbaustein oder ähnliches benutzt werden kann.

Aus den Dokumenten Tietze, Schenk "Halbleiter-Schaltungstechnik", 9. Auflage, 1990, Springer-Verlag, Berlin, bzw. Agrawal: _{"}Field Programmable Gate Arrays (FPGAs) provide ASICS system designers control of their design destiny", electro conference record, Bd.15, May 1990, Los Angeles, US, sind programmierbare logische Bauelemente zur Speicherung logischer Funktionen, deren Programmierung mittels leistungsfähiger Eingabemethoden softwaregestützt erfolgt, bekannt.

Die Aufgabe der vorliegenden Erfindung besteht darin, ein Verfahren anzugeben, das es ermöglicht, eine speicherprogrammierbare Steuerung, die einen Logikbaustein mit einem umfeldprogrammierbaren Logikfeld enthält, schnell und einfach zu programmieren.

Die Aufgabe wird durch folgende Verfahrensschritte gelöst:
- Aus einem vorgegebenen funktionalen Gesamtverhalten, z. B. aufgrund eines vorgegebenen funktionalen Schaltplans, insbesondere eines Funktionsplans für eine speicherprogrammierbare Steuerung, werden interne elektrische Konfigurationen, also Verbindungen und gegebenenfalls auch Logikfunktionen, des Logikfeldes bestimmt, welche das vorgegebene funktionale Gesamtverhalten realisieren, und
- die so bestimmten internen elektrischen Konfiguration, also Verbindungen und gegebenenfalls auch Logikfunktionen, werden dem Logikfeld eingeprägt,
- wobei unabhängig von dem vorgegebenen funktionalen Gesamtverhalten beim Festlegen der internen elektrischen Verbindungen ein Teil der im Prinzip frei festlegbaren internen elektrischen Verbindungen fest vorgegeben wird,
- wobei die Logikblöcke durch den fest vorgegebenen Teil der internen elektrischen Verbindung in Gruppen aufgeteilt werden, die zumindest teilweise gleiche Konfigurationen aufweisen.

Auf diese Weise werden regelmäßige Strukturen erzeugt, so daß das Logikfeld quasi in kleinere Einheiten, nämlich die Gruppen, zerlegt wird. Dadurch ist es möglich, das vorgegebene funktionale Gesamtverhalten in Teilfunktionen zu zerlegen, die zumindest teilweise in je einer Gruppe von Logikblöcken realisierbar sind.

Für Standard-Teilfunktionen, insbesondere komplexe Standard-Teilfunktionen, sind dabei interne elektrische Standard-Konfigurationen, also Verbindungen und gegebenenfalls auch Logikfunktionen, vorgebbar, wobei im Einzelfall die Standard-Teilfunktionen auch durch mehr als eine Gruppe von Logikblöcken realisierbar sein können.

Wenn Teilfunktionen und Standard-Teilfunktionen im Einzelfall sehr einfach sind, können gegebenenfalls mehrere von ihnen zusammengefaßt werden, sofern auch die Zusammenfassung in einer Gruppe von Logikblöcken realisierbar ist.

Die Programmierung des Logikfeldes erfolgt dann dadurch, daß
- die Teilfunktionen und/oder die Standard-Teilfunktionen und/oder die Zusammenfassung den Gruppen von Logikblöcken zugeordnet werden,
- unter Berücksichtigung der fest vorgegebenen internen elektrischen Verbindungen die internen elektrischen Verbindungen ermittelt werden, die die Gruppen von Logikblöcken derart miteinander und mit externen Anschlüssen verschalten, daß das vorgegebene funktionale Gesamtverhalten realisiert wird, und
- die so ermittelten internen elektrischen Verbindungen dem Logikfeld eingeprägt werden, vorzugsweise zusammen mit den fest vorgegebenen internen elektrischen Verbindungen.

Die Programmierung des Logikfeldes ist für den Anwender besonders einfach, wenn das funktionale Gesamtverhalten in einer Programmiersprache für speicherprogrammierbare Steuerungen vorgegeben wird, insbesondere in einer graphischen Programmiersprache.

Weitere Vorteile und Einzelheiten ergeben sich aus der nachfolgenden Beschreibung eines Ausführungsbeispiels, anhand der Zeichnungen und in Verbindung mit den weiteren Unteransprüchen. Es zeigen:
- FIG 1: mehrere Baugruppen einer modular aufgebauten speicherprogrammierbaren Steuerung,
- FIG 2: den inneren Aufbau einer Ein-/Ausgabe-Baugruppe,
- FIG 3: die Verbindungen zwischen Ein- und Ausgängen,
- FIG 4: den konstruktiven Aufbau einer Ein-/Ausgabe-Baugruppe,
- FIG 5: die innere Struktur eines umfeldprogrammierbaren Logikfeldes,
- FIG 6: den Aufbau eines Logikblocks,
- FIG 7: eine beispielhaft zu lösende Problemstellung in Form einer Ampelanlage,
- FIG 8: die zugehörige schalttechnische Realisierung der Ampelanlagensteuerung,
- FIG 9: die Vorabfestlegung der internen elektrischen Verbindungen,
- FIG 10: ein Beispiel einer internen elektrischen Standard-Verbindung,
- FIG 11: die Realisierung des vorgegebenen Gesamtverhaltens im umfeldprogrammierbaren Logikfeld und
- FIG 12: schematisch die Kommunikation zwischen Logikbaustein und Prozessor.

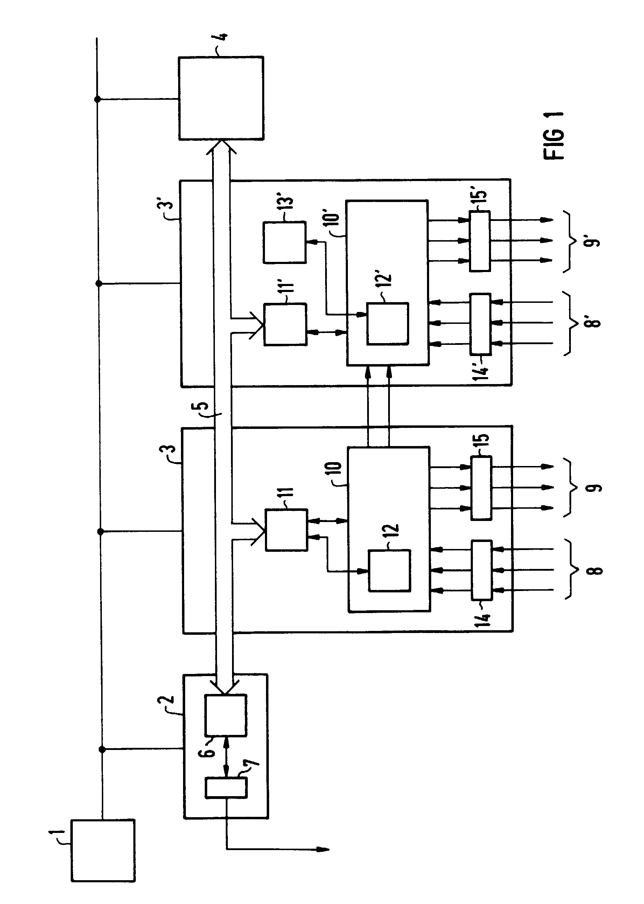

Gemäß FIG 1 besteht eine modular aufgebaute speicherprogrammierbare Steuerung aus einer Stromversorgung 1, einer Zentraleinheit 2, den Ein-/Ausgabe-Baugruppen 3, 3' sowie weiteren Peripherieeinheiten 4. Die Baugruppen 2, 3, 3', 4 sind dabei über einen Bus 5 miteinander verbunden. Die Zentraleinheit 2 weist mindestens einen Prozessor 6 zum Abarbeiten eines Programmes sowie eine Schnittstelle 7 zum Datenaustausch mit einem Programmiergerät auf.

Wie weiterhin aus FIG 1 ersichtlich ist, weist die Baugruppe 3 einen Logikbaustein 10 auf, der z.B. ein umfeldprogrammierbares Logikfeld (FPGA) sein kann. Der Logikbaustein 10 ist über den Prozessor 11 mit dem Bus 5 und damit auch mit der Zentraleinheit 2 verbunden. Dadurch ist es möglich, von einem Programmiergerät aus über die Zentraleinheit 2 die interne Verschaltung des Logikbausteins 10 derart zu programmieren, daß die Eingänge 8 über den Logikbaustein 10 gemäß zuvor aus dem abzuarbeitenden Programm abgeleiteten logischen Bedingungen zwischen Eingangs- und Ausgangssignalen mit den Ausgängen 9 verbunden sind. Der Anwender erstellt hierzu mit dem oben erwähnten Programmiergerät zwei Programmteile: Einen zeitunkritischen Teil und einen zeitkritischen Teil. Beide Teile werden vom Programmiergerät an den Prozessor 6 der Zentraleinheit 2 übertragen. Der zeitunkritische Teil wird in der Zentraleinheit 2 abgespeichert und, wie bei speicherprogrammierbaren Steuerungen allgemein üblich, sequentiell abgearbeitet. Der zeitkritische Teil wird vom Prozessor 6 weiter an die Logikbausteine 10, 10' übertragen und von diesen in eine logische Verschaltung umgesetzt.

Die beiden Programmteile sind völlig unabhängig voneinander. Es ist jedoch über Sonderbefehle möglich, daß der Prozessor 6 und die Logikbausteine 10, 10' Informationen austauschen.

Mit Vorteil werden dabei die logischen Bedingungen, die die Verschaltung des Logikbausteins 10 festlegen, in einen statischen Speicher 12 des Logikbausteins 10 übertragen und die Verschaltung des Logikbausteins 10 aufgrund des Inhalts des Speichers 12 bestimmt.

Die Baugruppe 3' weist ebenfalls einen Logikbaustein 10' mit einem statischen Speicher 12' auf, der Logikbaustein 10' wird jedoch über einen Anwenderspeicher 13' programmiert. Wenn die Verschaltung des Logikbausteins 10' geändert werden soll, muß der Anwenderspeicher 13' ausgetauscht bzw. umprogrammiert werden, da die logischen Bedingungen, die die Verschaltung des Logikbausteins 10' bestimmen, im Anwenderspeicher 13' abgespeichert sind.

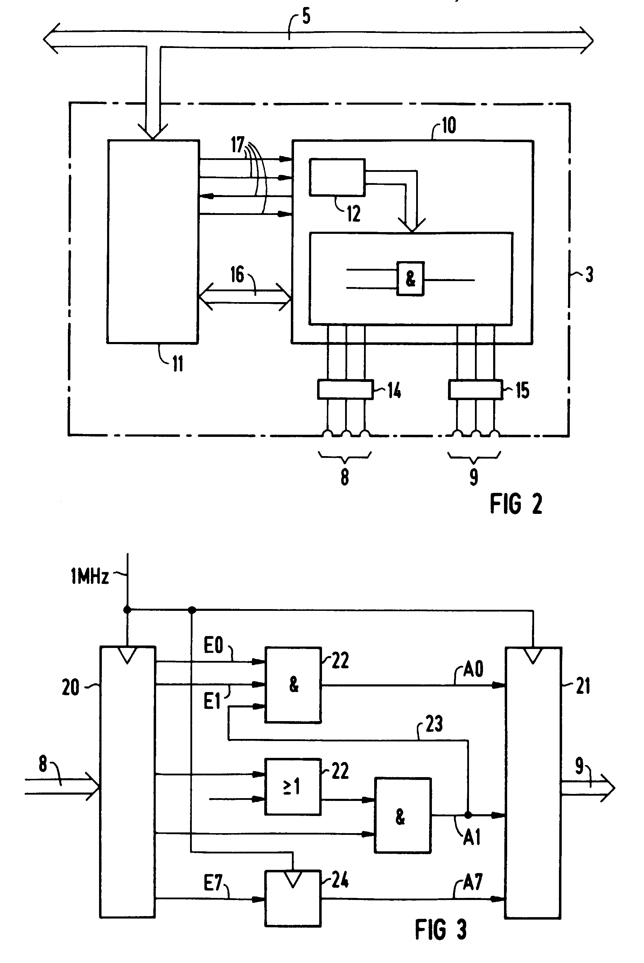

FIG 2 zeigt, in etwas geänderter Darstellung, den elektrischen Aufbau der Baugruppe 3. Wie aus FIG 2 ersichtlich ist, sind die Eingänge 8 mit dem Logikbaustein 10 über Eingangsfilter 14 und die Ausgänge 9 mit dem Logikbaustein 10 über Ausgangstreiber 15 verbunden. Dadurch wird erreicht, daß der Logikbaustein 10 bei einer versehentlichen Fehlverdrahtung bzw. bei einem Kurzschluß oder ähnlichen Fehlfunktionen nicht beschädigt wird. Weiterhin ist durch die Eingangsfilter 14 ein Entprellen der Eingangssignale möglich. Auch können über die Filter 14 und die Treiber 15 Signalpegelanpassungen vorgenommen werden, z.B. von 20mA auf 5 V.

Der Logikbaustein 10 ist über den Bus 16 sowie die Steuerleitungen 17 mit dem Prozessor 11 und damit auch mit dem Prozessor 6 verbunden. Dadurch wird es möglich, die korrekte Funktion des Logikbausteins 10 - auch während des Betriebs - zu überwachen. Zur Überwachung des Logikbausteins 10 können die Werte korrespondierender Eingänge 8 und Ausgänge 9 gleichzeitig zur Verarbeitung im Logikbaustein 10 an den Prozessor 11 und weiter an den Prozessor 6 übermittelt werden. Gegebenenfalls können auch Zwischenzustände des Logikbausteins 10, z. B. ein Merker oder ein Zählerstand, an den Prozessor 6 gemeldet werden. Es können auch neue Steuerungsparameter, z.B. neue Zeitkonstanten, an den Logikbaustein 10 übertragen werden.

Die in FIG 2 dargestellten Steuerleitungen 17 dienen beispielsweise der Übertragung eines Resetsignals, mit dem die internen Merker rücksetzbar sind, sowie der Meldung des Logikbausteins 10 an den Prozessor 6 über seinen derzeitigen Programmierzustand, also z.B. der Meldung "Programmierung Logikbaustein geändert". An dieser Stelle sei erwähnt, daß die Programmierung des Logikbausteins 10 nur dann geändert werden kann, wenn der Logikbaustein 10 inaktiv ist, d.h. wenn er nicht in die Steuerung eines Prozesses eingebunden ist. Wenn der Logikbaustein 10 aus mehreren unabhängig voneinander funktionsfähigen Teilen besteht, ist es auch möglich, daß nur der Teil, dessen Programmierung geändert wird, inaktiv ist.

Gemäß FIG 3 weist der Logikbaustein 10 ein Eingangslatch 20 und ein Ausgangslatch 21 auf, die beispielsweise mit einem Takt von 1 MHz getaktet sind. An die Eingänge des Eingangslatches 20 sind die Eingänge 8 angeschlossen. An die Ausgänge des Ausgangslatches 21 sind die Ausgänge 9 angeschlossen. Zwischen den Latches 20, 21 findet die eigentliche, parallele Verarbeitung der Signale statt. Hierzu wird beispielsweise im Logikschalter 22 eine elementare logische Verknüpfung der Eingänge E0 und E1 durchgeführt, gegebenenfalls auch mit Zwischenergebnissen, wie über die Leitung 23 angedeutet ist.

Das Ergebnis des Logikschalters 22 kann weiter verarbeitet werden oder auch direkt einem der Ausgänge zugeleitet werden, im gegebenen Fall dem Ausgang A0. Die Logikschalter 22 können, wie oben erwähnt, elementare logische Verknüpfungen durchführen, z.B. VERGLEICHEN, UND, ODER, NICHT-UND, NICHT-ODER. Um weitere, kompliziertere Funktionen realisieren zu können, ist es von Vorteil, wenn der Logikbaustein 10 speichernde Elemente 24 aufweist, aus denen dann z.B. Zähler, Zeitgeber oder Flankenmerker aufgebaut werden können.

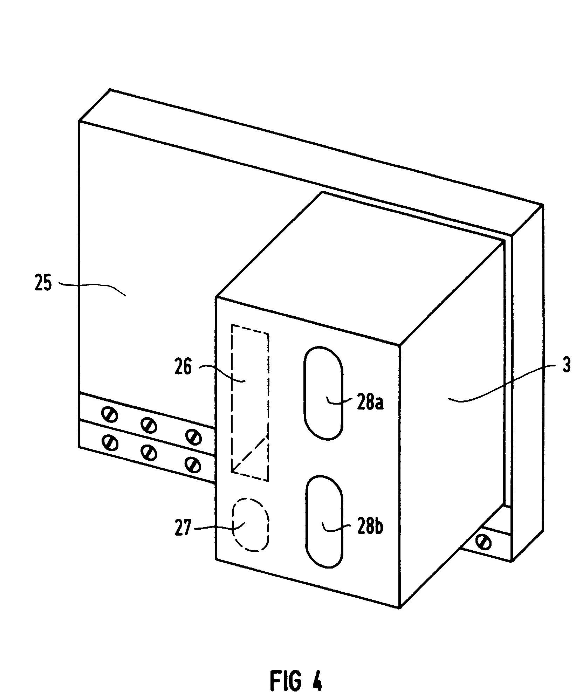

FIG 4 zeigt einen bevorzugten konstruktiven Aufbau der Ein-/ Ausgabe-Baugruppe 3. Wie aus FIG 4 ersichtlich ist, ist die Baugruppe 3 eine gekapselte Flachbaugruppe, die mit einem modular aufgebauten Baugruppenträger 25 verbunden ist. Die Baugruppe 3 weist einen Schacht 26 für das z.B. in FIG 1 dargestellte Anwendermodul 13' und eine Schnittstelle 27 zum Anschluß eines Programmiergeräts auf. Über das Anwendermodul 13' und die Schnittstelle 27 ist es möglich, den in der Baugruppe 3 enthaltenen Logikbaustein 10 direkt, d.h. nicht über den Prozessor 6, zu programmieren.

Weiterhin weist die Baugruppe 3 zwei Sub-D-Steckkontakte 28a, 28b, wobei die Kontakte 28a zum Anschluß von Sensoren und die Kontakte 28b zum Anschluß von Stellgliedern dienen.

Die Kernidee der vorliegenden Erfindung ist es, ein herkömmliches, sequentielles Anwenderprogramm für eine speicherprogrammierbare Steuerung soweit wie möglich auf die aus der Schütztechnik bekannten Strukturen abzubilden, d.h. die korrespondierenden Ein- und Ausgänge über Logikelemente direkt zu verdrahten. Hierzu werden die logischen Bedingungen eines in einer Programmiersprache für speicherprogrammierbare Steuerungen erzeugten Anwenderprogrammes in eine Verbindungsliste konvertiert und in einem Datenfeld abgelegt. Diese Daten werden dann in den Logikbaustein 10 geladen und führen dort zu einer entsprechenden internen Verschaltung des Logikbausteins 10. Dabei ist es, wie in FIG 1 gezeigt, möglich, mehrere dieser Logikbausteine 10, 10' seriell und/oder parallel miteinander zu verschalten. Der Programmablauf wird dadurch auf die Zentraleinheit 2 und die Baugruppen 3,3' verteilt.

Durch die direkte Verdrahtung korrespondierender Ein und Ausgänge miteinander entfällt für diese das bei konventionellen speicherprogrammierbaren Steuerungen benötigte Prozeßabbild. Weiterhin wird die speicherprogrammierbar Steuerung extrem schnell, die "Zykluszeit" geht tendenziell gegen Null. Auch wird das Alarmreaktionsverhalten reproduzierbarer, da die Alarmreaktionszeit besser eingehalten wird.

Im obenstehend beschriebenen Ausführungsbeispiel wurde der Logikbaustein in einem modular aufgebauten Automatisierungsgerät verwendet. Ebenso ist jedoch auch die Verwendung in einem allein betriebsfähigen Automatisierungsgerät möglich. In der Minimalversion dieses Automatisierungsgeräts weist das Automatisierungsgerät keinen Prozessor mehr, sondern nur noch den Logikbaustein auf, so daß das abzuarbeitende Programm vom Logikbaustein allein ausgeführt wird. Die Programmierung des Logikbausteins erfolgt in diesem Fall entweder über eine Schnittstelle zu einem Programmiergerät oder über ein Speichermodul, das vom Anwender programmiert wurde.

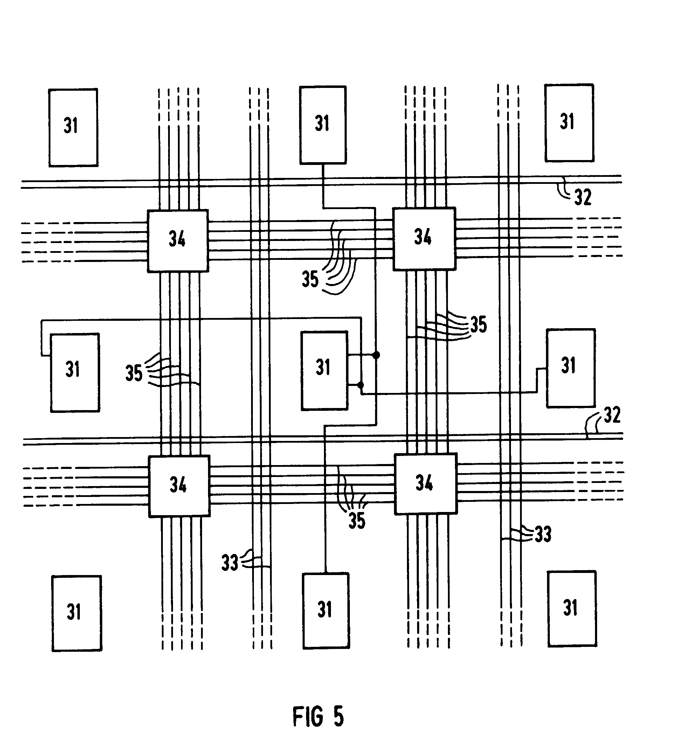

Die Logikbausteine 10, 10' sind im vorliegenden Fall umfeldprogrammierbare Logikfelder (FPGAs). Figur 5 zeigt einen Ausschnitt aus der inneren Struktur eines solchen Logikfeldes. Die innere Struktur weist eine zweidimensionale Matrix von z.B. 12 x 12 Logikblöcken 31 auf. Diese Matrix ist von einem Ring von Ein-/Ausgabe-Blöcken umgeben. Sowohl dem Anfang als auch dem Ende jeder (waagrechten) Reihe sind je zwei Ein-/ Ausgabe-Blöcke zugeordnet. Gleiches gilt für die (senkrechten) Spalten. Die Ein-/Ausgabe-Blöcke sind der Übersichtlichkeit halber nicht dargestellt. Weiterhin sind jeder Reihe von Logikblöcken 31 je zwei nicht unterbrechbare Verbindungen 32 und jeder Spalte drei Verbindungen 33, von denen zwei einmal in der Mitte der Spalte unterbrochen werden können, zugeordnet. Diese Anordnung von Logikblöcken 31 und Ein-/ Ausgabe-Blöcken ist durchsetzt von einem Netz mit 13 x 13 Schaltmatrizen 34, wobei benachbarte Schaltmatrizen 34 über je fünf Kurzverbindungen 35 miteinander verbunden sind.

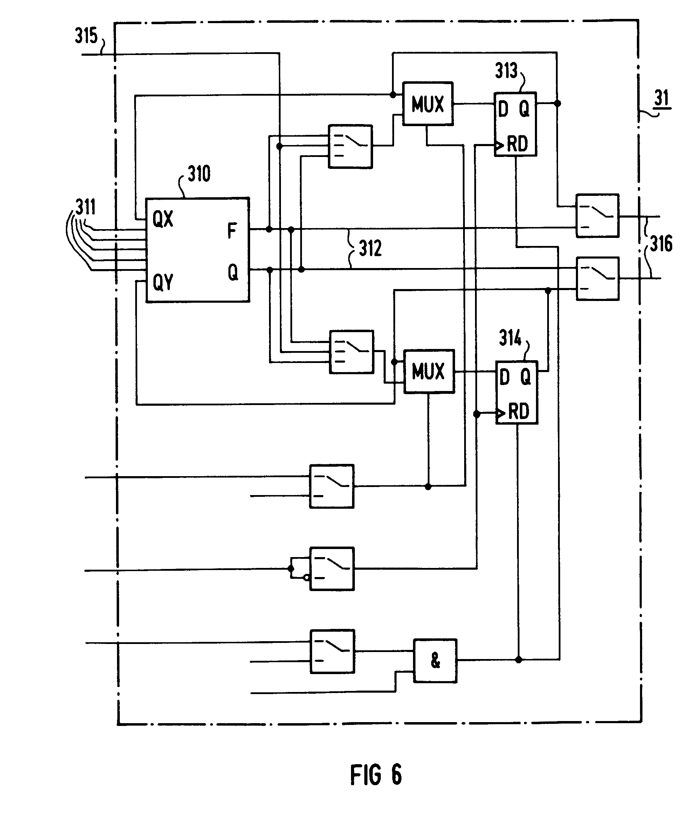

Die Logikblöcke 31 weisen gemäß Figur 6 einen Kombinatorikblock 310 auf, der aus maximal 5 Eingangsvariablen 311, zwei Ausgangsvariablen 312 ermittelt. Weiterhin weist der Logikblock 31 zwei Flipflops 313, 314 auf, deren Eingangssignal entweder aus einer der Ausgangsvariablen 312 des Kombinatorikblocks 310 oder aus einer direkt über den Eingang 315 eingegebenen Variable besteht. Die Ausgangssignale der Flipflops 313, 314 können entweder in den Kombinatorikblock 310 zurückgeführt werden oder aber als eines der Ausgangssignale 316 des Logikblocks 31 ausgegeben werden. Der Logikblock 31 ist also dahingehend programmierbar, welche logische und/ oder Speicherfunktion er ausführen soll.

Die beiden Ausgangsfunktionen des Logikblockes 31 sind im Prinzip unabhängig voneinander, werden im vorliegenden Fall jedoch stets gleich gewählt, da jeder der beiden Ausgänge 316 mit je zwei der vier nächsten Nachbarn seines Logikbausteins direkt verbindbar ist. Dadurch, daß die beiden Funktionen identisch sind, wird also erreicht, daß das Ausgangssignal jedes Logikblocks 31 seinen vier nächsten Nachbarn als Eingangssignal zur Verfügung gestellt werden kann. Die Topologie wird folglich strukturierter.

Weiterhin können die Ausgänge 316 mit den sie umgebenden Kurzverbindungen 35 sowie den sie umgebenden Langverbindungen 32, 33 verbunden werden. Auch sind an den Kreuzungspunkten zwischen den Langverbindungen 32, 33 untereinander sowie zwischen den Langverbindungen 32, 33 und den Kurzverbindungen 35 noch elektrische Verbindungen programmierbar.

Die Schaltmatrizen 34 sind ebenfalls programmierbar. Sie können eine Vielzahl der theoretisch denkbaren Verschaltungsmöglichkeiten realisieren, z.B. waagrechte und/oder senkrechte Durchverbindungen, Kontaktieren von waagrechten mit senkrechten Kurzverbindungen 35 und Aufteilen von einer Verbindung auf zwei oder drei.

Die Ein-/Ausgabe-Blöcke sind jeweils mit einem Anschlußpin des Chips verbunden und können wahlweise entweder ein Signal eingeben oder ausgeben, wobei dieses Signal wahlweise getaktet werden kann oder nicht.

Die Programmierung der Logikblöcke 31, der Schaltmatrizen 34 und der Ein-/Ausgabe-Blöcke ist jeweils lokal in diesen Elementen gespeichert, die hierzu einen kleinen statischen Speicher (SRAM) aufweisen.

Bezüglich weiterer Einzelheiten über umfeldprogrammierbare Logikbausteine wird auf Herstellerhandbücher verwiesen, z.B. auf Handbücher über die XC 3000 Logic Cell Array Familie von Xilinx.

Zum Programmieren derartiger Logikfelder existieren ASICDesign-Tools, mittels derer die Logikfelder in der Struktur des Logikfeldes angepaßten Stromlaufanweisungen programmierbar sind. Bei diesen Anweisungen muß der ASIC-Designer jedoch viele ASIC-spezifische Randbedingungen beachten. Solche Randbedingungen sind beispielsweise Gatterlaufzeiten, der Signalpegel von ungenutzten Gattereingängen usw. Es ist offensichtlich, daß eine derartige Programmierung hardwarenah und hochkomplex ist. Sie ist nur von ausgesprochenen Experten handhabbar.

Für das Umsetzen der gewünschten Programmierung in interne Verschaltungen des Logikbausteins 10 existieren Programme. Die Laufzeit dieser Programme, d.h. die Umsetzung des gewünschten Gesamtverhaltens in eine interne Verschaltung des Logikfeldes, beträgt, insbesondere wegen der vielfältigen Verbindungsmöglichkeiten, etliche Minuten, Stunden, manchmal sogar Tage.

Obenstehend erwähnte Spezialkenntnisse sind dem Anwender von speicherprogrammierbaren Steuerungen nicht zumutbar, ebensowenig die extrem langen Laufzeiten der Umsetzungsprogramme.

Der SPS-Anwender erwartet Laufzeiten im Sekunden-, höchstens Minutenbereich. Im folgenden wird daher anhand eines Beispiels ein Verfahren beschrieben, mittels dessen ein in einer dem SPS-Anwender vertrauten Programmiersprache vorgegebenes Gesamtverhalten schnell und einfach in eine interne Verbindung des Logikfeldes umgesetzt werden kann.

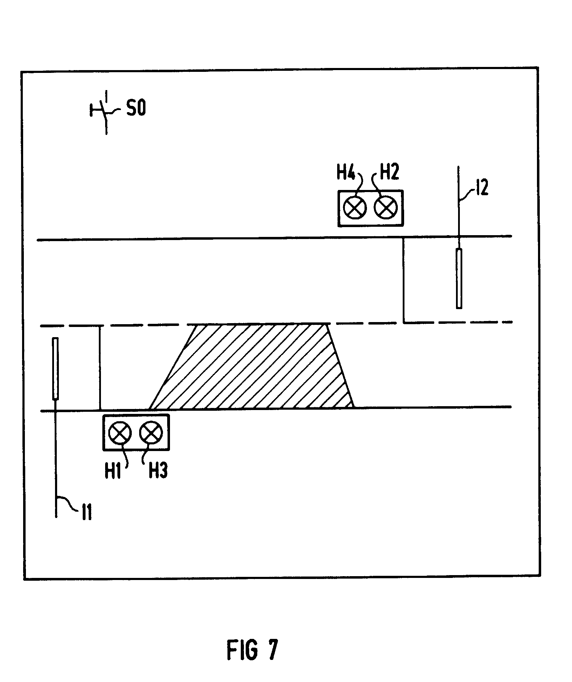

Das Beispiels ist der Aufgabensammlung Simatic S5 der Siemens AG, Bestell-Nr. E 80850-C 345-X-A1, entnommen und wird anhand von Figur 7 erläutert.

"Wegen Bauarbeiten muß der Verkehr auf einer Straße über eine Fahrspur geleitet werden. Da das Verkehrsaufkommen sehr hoch ist, wird eine Bedarfsampelanlage installiert. Beim Einschalten der Anlage zeigen beide Ampeln Rot. Wird ein Initiator betätigt, so schaltet die entsprechende Ampel nach 10 Sekunden auf Grün. Die Grünphase soll mindestens 20 Sekunden andauern, bevor durch eventuelle Betätigung des anderen Initiators beide Signallampen wieder Rot zeigen. Nach 10 Sekunden wird dann die andere Fahrspur mit Grün bedient. Liegt keine Meldung eines Initiators vor, so bleibt die Ampelanlage in ihrem jeweiligen Zustand. Das Ausschalten der Anlage soll nur nach der Grünphase einer Fahrspur möglich sein. Beim Einschalten der Steuerung muß der Grundzustand (MO) ohne Bedingung gesetzt werden."

Zur Umsetzung des Problems in eine SPS-Programmiersprache wird zunächst eine Umbenennung der Symbole vorgenommen wie in der untenstehenden Tabelle angegeben.

| Symbol | Operand | Kommentar |
|---|---|---|
| S0 | E0 | Schalter Ein (Schließer) |
| I1 | E1 | Initiator 1 (Schließer) |
| I2 | E2 | Initiator 2 (Schließer) |
| H1 | A1 | Grün |
| H2 | A2 | Grün |
| H3 | A3 | Rot |
| H4 | A4 | Rot |
| M0 | M0 | Grundzustand M0 |
| M1 | M1 | Zustand 1 |
| M2 | M2 | Zustand 2 |
| M3 | M3 | Zustand 3 |
| M4 | M4 | Zustand 4 |
| M5 | M5 | Zustand 5 |
| M6 | M6 | Zustand 6 |
| M7 | M7 | Zustand 7 |
| | T1 | Zeit 10 Sekunden |
| | T2 | Zeit 20 Sekunden |
| | KT 100.1 | Zeit für Zähler 1 |
| | KT 200.1 | Zeit für Zähler 2 |

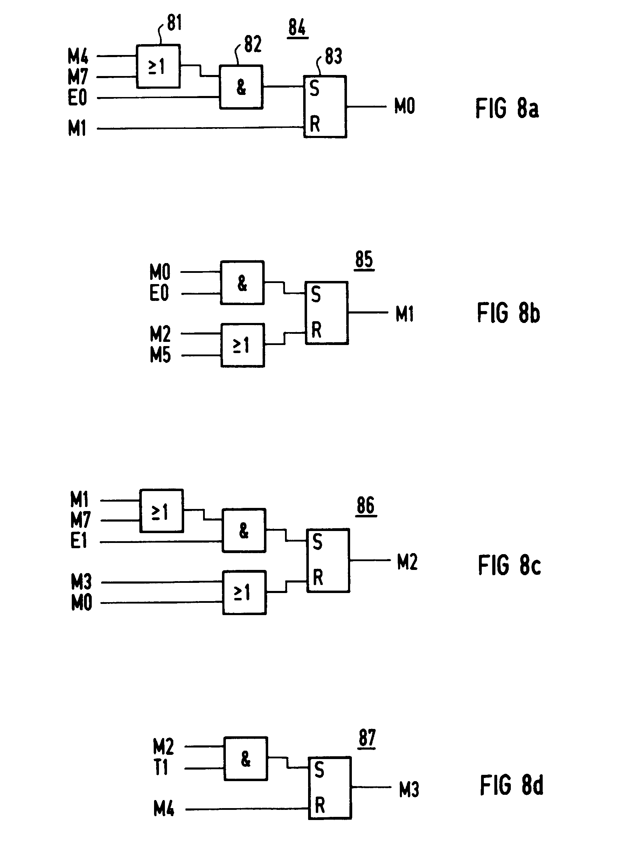

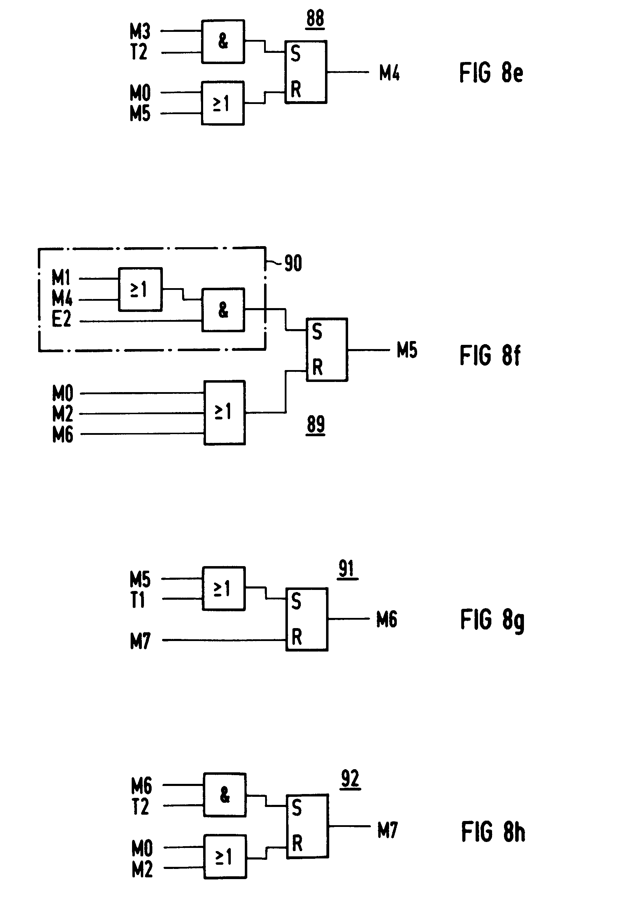

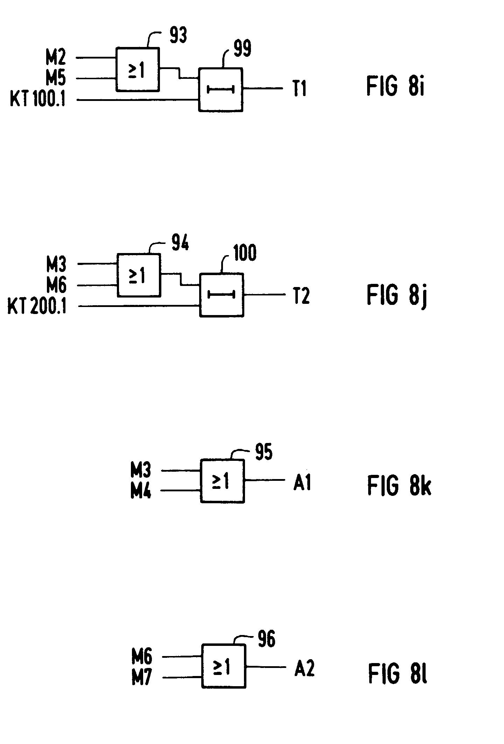

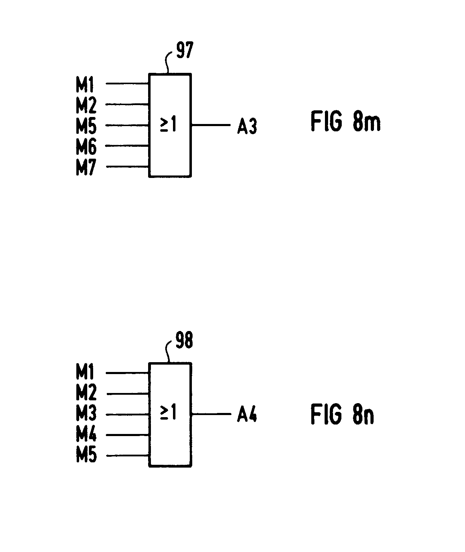

Die zugehörige Verschaltung stellt sich in der SPS-Programmiersprache FUP (= Funktionsplan) wie in FIG 8 gezeigt dar. Diese Art der Programmierung kennt der SPS-Anwender, und sie ist ihm geläufig. Die Aufgabe besteht darin, das vorgegebene, in einer SPS-Programmiersprache formulierte Gesamtverhalten schnell und einfach in eine FPGA-Struktur umzusetzen, so daß der SPS-Anwender im Ergebnis in die Lage versetzt wird, den Logikbaustein 10 selbst zu programmieren.

Erreicht wird dies dadurch, daß das Programm, das das SPS-Anwenderprogramm in die zugehörige interne Verschaltung des Logikbausteins 10 umsetzt, die theoretisch mögliche Komplexität des Logikbausteins 10 von vorneherein nur zu einem kleinen Bruchteil ausnutzt. Dies geschieht dadurch, daß ein Teil der im Prinzip frei wählbaren Verbindungen, z.B. die interne Verschaltung der Schaltmatrizen 34, im Umsetzungsprogramm fest vorgegeben wird, also vom Ersteller des SPS-Anwenderprogramms nicht beeinflußbar ist. Konkret werden die Verschaltungen der Schaltmatrizen 34 jeder der dreizehn senkrechten Spalten derart vorgegeben, daß zum einen die oberste, die unterste sowie die mittleren drei der Schaltmatrizen 34 einer Spalte die waagerecht verlaufenden Kurzverbindungen 35 1:1 durchverbinden und die anderen der Kurzverbindungen 35 vorerst noch nicht verbinden und zum anderen die übrigen Schaltmatrizen 34 nur die senkrechten der Kurzverbindungen 35 1:1 durchverbinden und die waagrechten Kurzverbindungen 35 blokkieren.

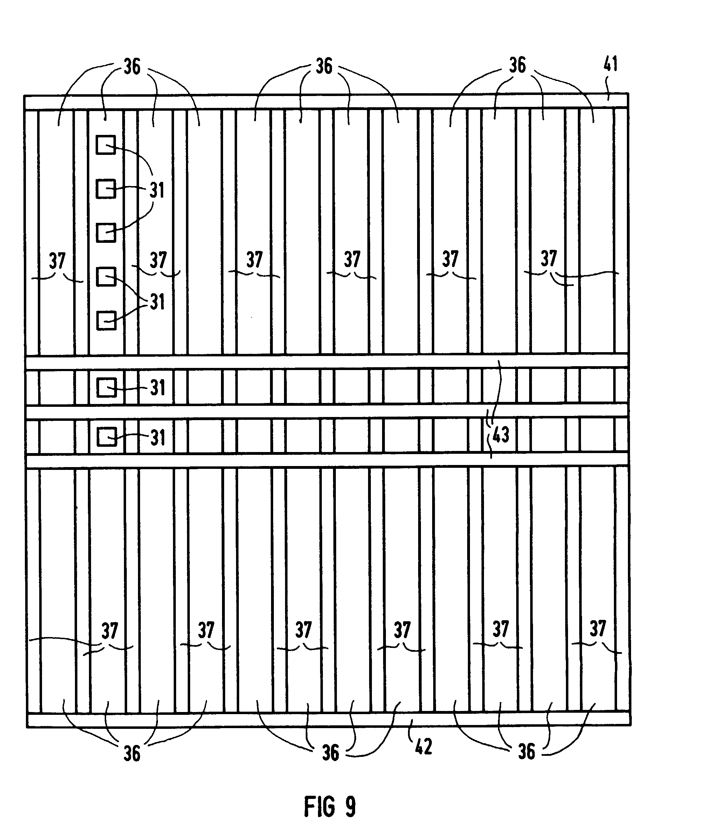

Es ergibt sich dadurch eine Struktur wie sie in Figur 9 dargestellt ist: Es werden Gruppen 36 gebildet, die je fünf untereinander angeordnete Logikblöcke 31 enthalten und die vorne und hinten jeweils von fünf sich über die Länge einer "Halbspalte" erstreckenden Kurzverbindungen 37 umgeben sind. Auf diese Gruppen 36 wird die zu realisierende Schaltung von FIG 8 auf noch zu erläuternde Art und Weise abgebildet. Die beiden waagrechten mittleren Reihen von Logikblöcken 31 werden auf ebenfalls noch zu erläuternde Art und Weise zur Erzeugung von Taktsignalen genutzt.

Die so entstandenen Gruppen 36 weisen eine handliche Größe auf: Einerseits ist ihre Komplexität klein genug und daher überschaubar genug, um auf relativ einfache Art und Weise abschätzen zu können, ob ein Teilnetzwerk der zu realisierenden Gesamtschaltung durch eine der Gruppen 36 realisierbar ist, andererseits sind die Gruppen aber auch groß genug, um die Gesamtschaltung von FIG 8 nicht in zu kleine Teilnetzwerke zerstückeln zu müssen. Als Kriterium zur Auswahl der Teilnetzwerke dienen die zur Verfügung stehenden Verbindungsresourcen und die zur Verfügung stehende Logikkapazität der Gruppen 36. Jedes Teilnetzwerk wird derart bemessen, daß es folgende Kriterien erfüllt:
a) es weist maximal fünf Eingangssignale auf;
b) es weist maximal fünf Ausgangssignale auf;
c) es werden zur Realisierung des Teilnetzwerks maximal fünf der Logikblöcke 31 benötigt und
d) die Verdrahtung des Teilnetzwerks innerhalb der Gruppe 36 ist möglich.

Beginnend beim Oder-Gatter 81 in FIG 8 erkennt man sofort, daß auch das Und-Gatter 82 im selben Logikblock 31 realisierbar ist, da auch die Zusammenfassung dieser beiden Funktionen erst eine kombinatorische Funktion mit drei Eingängen und einem Ausgang ergibt. Dem RS-Flipflop 83 dagegen wird ein eigener Logikblock 31 zugewiesen, da jeder der Logikblöcke 31 aufgrund einer (willkürlichen) Compilervorschrift nur entweder eine kombinatorische Funktion ausführen oder eine Speicherfunktion wahrnehmen darf. Das Teilnetzwerk 84 kann folglich in einer Gruppe 36 realisiert werden, da insgesamt nur vier Eingangssignale, ein Ausgangssignal und zwei Logikblökke 31 benötigt werden, die Kapazität einer Gruppe 36 also nicht überschritten wird.

Aufgrund ähnlicher Überlegungen ist leicht ersichtlich, daß auch die Teilnetzwerke 85 bis 88 in je einer Gruppe realisierbar sind. Vom nächsten Netzwerk 89 muß jedoch das Teilnetzwerk 90 abgetrennt werden, da sonst die Zahl der Eingänge den maximal zulässigen Wert von fünf überschritte. Analog werden die anderen Netzwerke 91 bis 100 der Gesamtschaltung aufgeteilt, aber noch nicht bestimmten Gruppen 36 zugeordnet.

Eine gewisse Schwierigkeit bei der Aufteilung der einzelnen Netzwerke bereitet die Realisierung der Zeitglieder 99 und 100, da einem Zeitglied in der "SPS-Welt" kein entsprechendes Gegenstück in der "FPGA-Welt" gegenübersteht. Um dem SPS-Anwender dennoch die leichte Programmierung von Zeitgliedern zu ermöglichen, wird diese für speicherprogrammierbare Steuerungen (SPSen) oft benötigte Funktion dem Anwender als Funktionsmakro zur Verfügung gestellt.

Zur Compilerlaufzeit erkennt der Compiler, daß ein Funktionsmakro vorliegt und setzt diesen Makro in eine interne, innerhalb des Logikfeldes verschiebbare Standard-Verbindung um. Die interne Standard-Verbindung wurde dabei vorab vom Compilerhersteller bzw. vom ASIC-Designer bestimmt. Dadurch wird der Compiler nicht in nennenswertem Umfang mit der Ermittlung der Verbindungen belastet, die den Funktionsmakro realisieren.

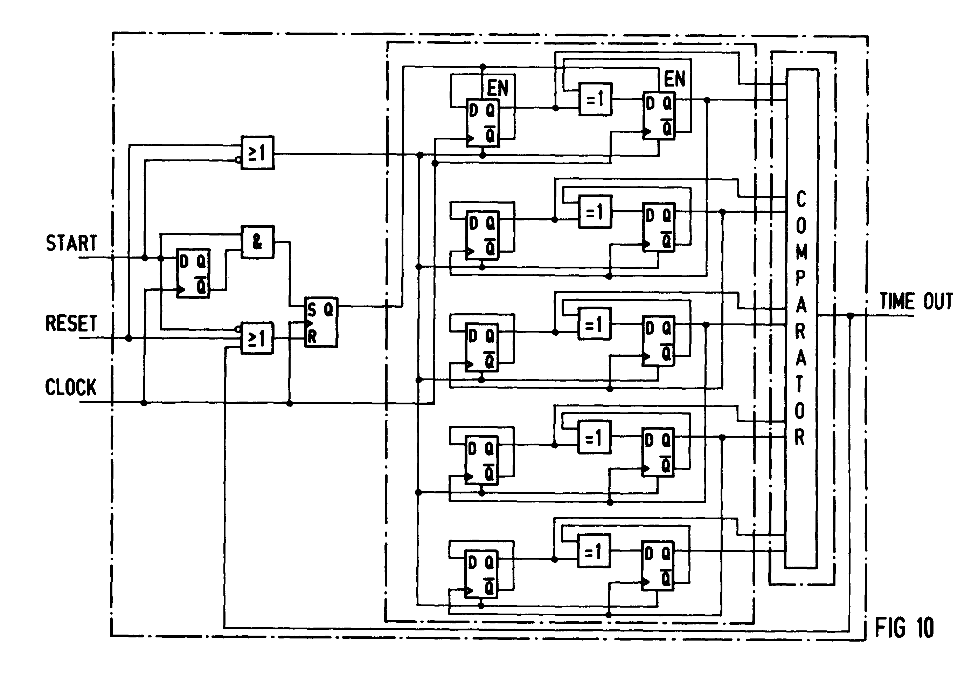

FIG 10 zeigt ein Beispiel einer solchen Standard-Verbindung für einen Zeitzähler, der bis zu 210 Taktzyklen abzählen kann. Die tatsächlich zählbare Zeit ist selbstverständlich noch von der Taktung des Zählers abhängig.

Das in FIG 10 gezeigte Beispiel benötigt drei nebeneinanderliegende Gruppen 36 von Logikblöcken 31. Die genaue Abbildung der in FIG 10 dargestellten Logik auf FPGA-Strukturen ist dabei für den SPS-Anwender irrelevant. Bei der Erstellung derartiger Hardmakros, die mit Standard-ASIC-DesignTools erfolgt, muß der Compiler-Hersteller bzw. der ASICDesigner jedoch darauf achten, daß nur lokale Verbindungen, also direkte Verbindungen und Kurzverbindungen 35, verwendet werden, nicht aber globale Langverbindungen 32, 33. Hierdurch sind diese Makros nicht nur innerhalb des Logikfeldes leicht verschiebbar, also relocierbar. Sie sind auch unabhängig von den sie umgebenden Netzwerken oder Makros placierbar.

Da Hardmakros dem SPS-Programmierer (oder -Anwender) über eine Bibliothek zur Verfügung gestellt werden, die Makros also vorab erstellt worden sind, ist die interne Konfiguration eines solchen Makros auch nicht an die begrenzten Möglichkeiten der Anwenderprogrammierung gebunden, sondern es kann die volle Komplexität des beanspruchten Feldbereichs ausgenutzt werden. Die Restriktionen der Anwenderprogrammierung können entfallen.

Die Erstellung derartiger Hardmakros durch den Compiler-Hersteller bzw. den ASIC-Designer und auch der Lauf der Umsetzungsprogramme kann zwar Stunden oder sogar Tage dauern. Dies ist in diesem Fall aber möglich und tolerierbar. Zum einen sind nämlich nur 3 x 5 = 15 der Logikblöcke 31 statt 12 x 12 = 144 Logikblöcke 31 miteinander zu verschalten. Zum anderen werden die Makros, wie bereits erwähnt, vorab erstellt. Der Anwender wird folglich nicht mit der Erstellung dieser Makros belastet, sondern sie stehen ihm sofort zur Verfügung. Das Zuordnen des Hardmakros zu einer bestimmten Stelle im FPGA dauert aber nur Bruchteile von Sekunden. Beim Design des Hardmakros ist lediglich zu beachten, daß die vier Ein- bzw. Ausgänge "Start", "Reset", "Clock" und "Zeitablauf" leicht zugänglich sind.

Für andere mögliche Standard-Funktionen der "SPS-Welt" sind selbstverständlich gegebenenfalls auch größere oder kleinere dieser Hardmakros möglich.

Nach der Aufgliederung der Gesamtschaltung in Teilnetzwerke 84 bis 98 werden diese zusammengefaßt, soweit auch die Zusammenfassung die obenstehend beschriebenen Kriterien a) bis d) erfüllt. Es ergibt sich beispielsweise, daß die Teilnetzwerke 87 und 94 sowie die Teilnetzwerke 93 und 97 zusammenfaßbar sind. Dieser soeben beschriebene Schritt ist nicht unbedingt nötig, er erhöht aber den Ausnutzungsgrad des Logikfeldes.

Falls wider Erwarten im Einzelfall zur Realisierung der gewünschten Verschaltung die Zahl von fünf Eingängen bzw. fünf Ausgängen überschritten werden muß, kann dies dadurch realisiert werden, daß - je nach Bedarf - eine oder mehrere Gruppen 36 vor der Gruppe 36, die mehr als fünf Eingangssignale benötigt, freigelassen werden und diese Signale ausnahmsweise mittels der waagrechten Kurzverbindungen und/oder der direkten Verbindungen von Logikblöcken 31 der davorliegenden Gruppe 36 der Gruppe 36 zugeführt werden, die mehr als fünf Eingänge benötigt. Falls auch diese zusätzlichen Verbindungsmöglichkeiten nicht ausreichen, wird eine Fehlermeldung generiert "gewünschte Schaltung nicht generierbar, Verbindungsmöglichkeiten zu gering".

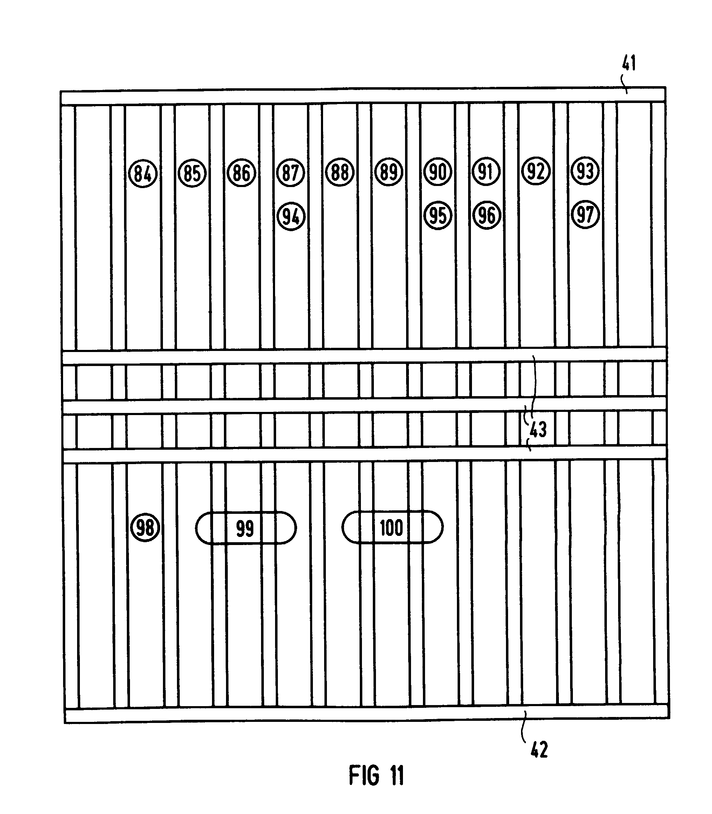

Die einzelnen Teilnetzwerke 84 bis 100 werden nunmehr den einzelnen Gruppen 36 zugeordnet so wie in Figur 11 dargestellt. An dieser Stelle sei erwähnt, daß die Zuordnung der Teilnetzwerke 84 bis 100 auf die einzelnen Gruppen 36 gemäß ihrer Reihenfolge vorgenommen wurde. Dies ist die einfachste Art und Weise, eine Zuordnung vorzunehmen; es sind aber auch komplexere Lösungen denkbar, die bereits die Verbindungen der Teilnetzwerke 84 bis 100 untereinander berücksichtigen. Die außenliegenden Gruppen 36 werden nicht belegt, da die außenliegenden verlängerten Kurzverbindungen 37 nicht zur Anbindung dieser Gruppen zur Verfügung stehen, sondern anderweitig benötigt werden. Diese anderweitige Verwendung wird später noch erläutert werden.

Ein Beispiel einer komplexeren Lösung bei der Zuordnung der Teilnetzwerke 84 bis 100 auf die einzelnen Gruppen 36 bestünde beispielsweise darin, das Netzwerk 98 in der äußersten rechten Gruppe 36 anzuordnen. Dieses Netzwerk hat nämlich als einzigen Ausgang den Prozeßausgang A4. Dieser Prozeßausgang aber könnte direkt auf einen Ein-/AusgabeBlock gelegt werden. Es würden also weder verlängerte Kurzverbindungen 37 noch sonstige globale Verbindungsresourcen benötigt.

Nach der Zuordnung der Teilnetzwerke 84 bis 100 zu den Gruppen 36 werden die internen elektrischen Verbindungen festgelegt. Hierbei werden zunächst soweit als möglich die direkten Verbindungen zwischen den Logikblöcken 31 ausgenützt. Im vorliegenden Beispiel der Ampelschaltung sind dies nur wenige; zumeist läßt sich nur der Merkerausgang der Teilnetzwerke 84 bis 91 in das jeweils nächste Netzwerk weiterverbinden.

Selbst dies ist im vorliegenden Fall aber nicht sinnvoll, da die Ausgangssignale der einzelnen Teilnetzwerke auch anderweitig benötigt werden und daher in jedem Fall auf globalere Verbindungen zurückgegriffen werden muß.

Als erstes werden die Ein- und Ausgangssignale vom und zum zu steuernden Prozeß verbunden, also die Eingangssignale E0 bis E2 und die Ausgangssignale A1 bis A4. Soweit möglich, werden die Ein- und Ausgangssignale direkt über die waagrechten Langverbindungen 32 den äußersten der verlängerten Kurzverbindungen 37 zugeführt. Falls die waagrechten Langverbindungen 32 bereits belegt sind, z.B. weil drei Signale anzuschließen sind, aber nur zwei waagrechte Langverbindungen 32 zur Verfügung stehen, werden die Signale zunächst auf senkrechte Langverbindungen 33 oder auf senkrechte Kurzverbindungen 37 gelegt. Dann werden sie über eine einer anderen Reihe von Logikblöcken 31 zugeordneten Langverbindung 32 an den Rand des Logikfeldes geführt. An den Rändern des Logikfeldes werden die Ein- und Ausgangssignale mittels der verlängerten Kurzverbindungen 37 derart weiterverbunden, daß z.B. das logische Eingangssignal E0 an den physikalischen Prozeßeingang E0 angeschlossen ist.

Durch einfaches Abzählen der verbleibenden internen Ein- bzw. Ausgänge der einzelnen Netzwerke 84 bis 100 ergibt sich sodann, daß ausnahmslos stets die fünf verlängerten Kurzverbindungen 37 zwischen den Teilnetzwerken 84 bis 100 ausreichen, um die Ein-und Ausgänge der Teilnetzwerke 84 bis 100 senkrecht miteinander zu vernetzen. Falls im Einzelfall mehr als fünf Leitungen benötigt werden würden, würde zur vollständigen Verbindung auf die senkrechten Langverbindungen 33 zurückgegriffen werden, vorzugsweise zunächst auf die unterbrechbaren der Langverbindungen 33.

Durch ebensolches einfaches Abzählen ergibt sich weiterhin, daß nunmehr nur noch dreizehn verschiedene Signale innerhalb des Logikfeldes geführt werden müssen, nämlich die acht Merkersignale M0 bis M7, die zwei Timer-Signale T1 und T2 sowie 3, interne Signale vom Teilnetzwerk 90 zum Teilnetzwerk 89, vom Teilnetzwerk 93 zum Teilnetzwerk 99 und vom Teilnetzwerk 94 zum Teilnetzwerk 100.

Nunmehr ist jedoch offensichtlich, daß diese interne Verbindung leicht möglich ist. Es werden nämlich einfach nacheinander die internen Ausgangssignale in der Reihenfolge ihres Entstehens auf die beiden äußeren der drei mittleren Kurzverbindungsleisten 43 gelegt. Hierdurch sind zehn interne Signale innerhalb des gesamten Logikfeldes abgreifbar. Sie stehen damit überall als interne Eingangssignale zur Verfügung.

Die drei noch zu verbindenden internen Ausgangssignale werden auf drei der waagrechten Langverbindungen 32 gelegt, so daß sie ebenfalls abgegriffen werden können, wo sie benötigt werden. Falls eines dieser drei Signale in der oberen Reihe der Gruppen 36 als Ausgangssignal anfällt, jedoch in der unteren Reihe von Gruppen 36 benötigt wird, wird dieses Problem wie folgt gelöst: Das jeweilige interne Ausgangssignal wird auf eine der waagrechten Langverbindungen 32 in der oberen Hälfte des Logikfeldes gelegt, diese waagrechte Langverbindung 32 mit einer senkrechten Langverbindung 33 verbunden und die senkrechte Langverbindung 33 mit einer waagrechten Langverbindung 32 verbunden, die in der unteren Hälfte des Logikfeldes angeordnet ist. Hierdurch steht dieses Signal auch in der unteren Hälfte des Logikfeldes zur Verfügung.

In analoger Weise wird selbstverständlich verfahren, wenn ein internes Signal in der unteren Hälfte des Logikfeldes erzeugt, jedoch in der oberen Hälfte als Eingangssignal benötigt wird.

Darüber hinaus lassen sich bei vorausschauender Anordnung der Netzwerke 84 bis 100 innerhalb des Logikfeldes drei der internen Signale direkt verbinden, so daß für die dann noch verbleibenden zehn internen Signale die beiden äußeren der Kurzverbindungsleisten 43 ausreichen.

Die oben stehend erwähnten drei internen Signale fallen nämlich jeweils nur einmal als Ausgangssignal an, nämlich in den Teilnetzwerken 90, 93 und 94, und werden auch nur einmal als Eingangssignale benötigt, nämlich von den Teilnetzwerken 89, 99 und 100. Wenn also die Teilnetzwerke 90 und 89, 93 und 99 sowie 94 und 100 jeweils unmittelbar hintereinander angeordnet werden, können diese Signale direkt über Nächste-Nachbar-Verbindungen der Logikblöcke 31 untereinander verbunden werden. Auch ist eine Verbindung über die zwischen den jeweiligen Teilnetzwerkpaaren liegende verlängerte Kurzverbindung 37 möglich. In beiden Fällen werden keine waagrechten Verbindungen 32, 41, 42, 43 benötigt. Diese Verbindungen stehen damit anderweitig zur Verfügung.

Für die Taktung der Zeitzähler 99, 100 werden innerhalb des Logikfeldes Systemtakte von 1 ms, 10 ms, 100 ms und 1000 ms bereitgestellt. Dies geschieht auf folgende Art und Weise:

Mittels ASIC-Design-Tools werden vom Compiler-Hersteller vorab Teilerstufen erstellt, die einen beliebigen, von außen eingekoppelten Systemtakt auf ein 1/10, 1/100 und 1/1000 seiner ursprünglichen Frequenz herunterteilen. Dieser Makro, im folgenden Teilermakro genannt, wird dabei derart erstellt, daß er nur die beiden mittleren, bisher ungenutzen Reihen von Logikblöcken 31 sowie die direkten Verbindungen zwischen diesen Logikblöcken benötigt. Dieser Teil der (System-) Programmierung des FPGAs steht fest und ändert sich nicht. Von außerhalb des Logikbausteins 10 wird über einen der Ein-Ausgabe-Puffer ein Takt von 1 ms direkt in diesen Teilermakro eingekoppelt.

Die vier FPGA-internen Systemtakte von 1, 10, 100 und 1000 ms werden beispielsweise je einer der vier waagrechten Langverbindungen 32 zugeteilt, die den beiden mittleren Reihen von Logikblöcken 31 zugeordnet sind. Diese vier Zeittakte stehen damit im ganzen Logikfeld bereit und können dementsprechend abgegriffen werden. Welcher der Systemtakte an die Zeitzähler 99, 100 angeschlossen wird, ergibt sich für den Compiler aus der Bezeichnung der Eingangsvariablen KT x.y. x bezeichnet nach allgemeiner Regelung die Zahl der zu zählenden Taktzyklen und y ist ein Code für die Zeiteinheit. 200.1 bedeutet also beispielsweise, daß 200 Zyklen des Taktes mit dem Code 1, d.h. 100 ms, zu zählen sind. Im Ergebnis mißt der Zeitzähler 100 also 200 x 100 ms = 20 sec. Zum ordnungsgemäßen Ablauf des Steuerungsprogramms müssen im Regelfall die Logikbausteine 10, 10' und die Zentraleinheit 2 auch während des Betriebs Daten miteinander austauschen. Es kann beispielsweise sein, daß die Parametrierung des Logikbausteins 10 während des Betriebs geändert werden soll. Weiterhin sollte die Zentraleinheit 2 zumindest zeitweise über den aktuellen Zustand des Logikbausteins 10 (bzw. 10') informiert werden. Der Prozessor 6 und die Logikbausteine 10, 10' sind jedoch nicht miteinander synchronisiert. Es stellt sich daher das Problem der Datenkonsistenz. Das Problem wird dadurch noch vergrößert, daß der Datenverkehr zwischen Prozessor 6 und Logikbausteinen 10, 10' seriell verläuft. Der serielle Datenverkehr ist nötig, da ansonsten zu viele Pins der Logikbausteine 10, 10' für den Datenverkehr mit dem Prozessor 6 benötigt würden.

Das Problem wird dadurch gelöst, daß dem Anwender weitere Funktionsmakros zur Verfügung gestellt werden. Diese Funktionsmakros realisieren Schieberegister, die der Zwischenspeicherung von Ein- oder Ausgabedaten dienen, sowie Arbeitsspeicher. Dabei werden zunächst die neu einzugebenden Daten vom Prozessor 6 in die Schreibzwischenspeicher z.B. des Logikbausteins 10 eingeschrieben. Während dieser Zeit sind die in den Zwischenspeichern abgespeicherten Werte zwar im Logikbaustein 10 vorhanden, werden aber vorerst nicht verwendet, da sie vorerst noch nicht freigegeben wurden. Mittels eines eigenen Befehls werden sodann die neu in den Logikbaustein 10 eingeschriebenen Werte von den Zwischenspeichern in die Arbeitsspeicher übernommen. Gleichzeitig werden die aus dem Logikbaustein 10 auszulesenden Werte in andere, sogenannte Lesezwischenspeicher eingelesen. Sodann werden die Daten seriell aus diesen Lesezwischenspeichern in den Prozessor 6 ausgelesen.

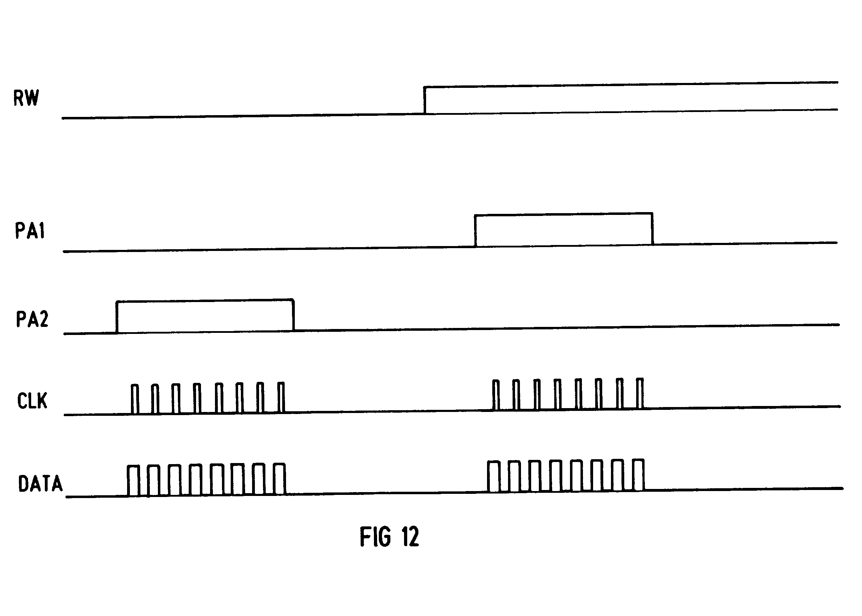

FIG 12 zeigt ein Beispiel eines solchen Datenzyklus. Im vorliegenden Fall werden zum Übertragen aller benötigten Signale fünf Leitungen benötigt. Dabei werden auf den Leitungen folgende Informationen übertragen:

Solange der Signalpegel der Leitung RW Null ist, können Daten in die Schreibzwischenspeicher geschrieben werden. Solange der Signalpegel der Leitung RW 1 ist, können Daten aus den Lesezwischenspeichern gelesen werden. Alle Zwischenspeicher sind derart an die Leitung RW angeschlossen, daß sie auf die ansteigende Signalflanke der Leitung RW getriggert sind. Zum Triggerzeitpunkt werden zum einen die Daten aus den Schreibzwischenspeichern in die Arbeitsspeicher übernommen. Zum anderen werden Daten aus den Logikblöcken 31 in die dafür vorgesehenen Lesezwischenspeicher übernommen.

Die Signale PA1 und PA2 sind Adreßsignale. Mittels der Adreßsignale PA1 und PA2 können maximal je drei Schreibzwischenspeicher und Lesezwischenspeicher adressiert werden. Der theoretisch mögliche vierte Speicher (2 Signale = 2² = 4 Adressierungsmöglichkeiten) darf nicht verwendet werden. Diese Pegel werden nämlich an den Logikbaustein 10 angelegt, wenn keine Daten eingelesen bzw. ausgelesen werden. Daher darf diese Adresse, z.B. die Doppelnull, nicht verwendet werden.

CLK ist ein Takt. Wenn CLK Eins ist, liest der jeweils angesprochene Zwischenspeicher ein neues Bit ein bzw. aus.

Data ist die Datenleitung, auf der die Information selbst übertragen wird. Im vorliegenden Beispiel werden (rein zufällig) lauter Einsen übertragen.

Es ergibt sich aufgrund einfacher Überlegung, daß zum Lesen bzw. Schreiben der Zwischenspeicher mindestens vier Leitungen benötigt werden, nämlich die Leitungen RW, CLK, Data sowie mindestens eine Adreßleitung. Diese vier Signale werden auf die mittlere, bisher ungenutzte der drei Kurzverbindungsleisten 43 gelegt. Dadurch stehen diese vier Signale quer über den gesamten Logikbaustein 10 zu Verfügung. Falls überhaupt keine Parameter ein- und auszulesen sind, steht auch die mittlere der drei Kurzverbindungsleisten 43 für die interne Verbindung der Gruppen 36 zur Verfügung.

Falls mehr als drei Lesezwischenspeicher bzw. Schreibzwischenspeicher zu adressieren sind, werden weitere Adreßsignale PA3, PA4 etc. an den Logikbaustein 10 angelegt. Diese zusätzlichen Adreßsignale werden im Regelfall auf zwei waagrechte Langverbindungen 32 gelegt, wobei die eine der Langverbindungen 32 in der oberen Hälfte des Logikfeldes und die andere in der unteren Hälfte des Logikfeldes angeordnet ist.

Es bedarf keiner Erwähnung, daß die Bildung von zusätzlichen Speichermakros Logikfeldkapazitäten beansprucht. Diese Logikfeldkapazitäten stehen selbstverständlich anderweitig nicht mehr zur Verfügung.

Die obenerwähnten Speichermakros sind, ebenso wie die Timer, vorab vom Compilerhersteller mit ASIC-Design-Tools erstellt worden. Dem Compilerhersteller ist dabei im Rahmen seines allgemeinen Fachwissens bekannt, wie Register und Schieberegister aufzubauen sind. Ebenso ist in der Elektronik allgemein bekannt, wie Schieberegister mittels Adreßleitungen anzusteuern sind, so daß nur jeweils eines angesprochen wird. Derartige Speicherkonfigurationen bedürfen daher im Rahmen der vorliegenden Erfindung keiner weiteren Erläuterung.

Damit sind nun alle wesentlichen Schritte zur schnellen und einfachen Umsetzung eines SPS-Programms in eine FPGA-Struktur bekannt. Die nunmehr bekannten internen elektrischen Verbindungen und die nunmehr ebenfalls ermittelte Programmierung der einzelnen Logikblöcke 31 werden in an sich bekannter Weise dem Logikfeld eingeprägt, so daß es also das gewünschte Gesamtverhalten, hier die Ampelsteuerung, realisiert. Weiterhin erhält der Anwender eine Meldung über den Ausnutzungsgrad des Logikfeldes oder, falls die Realisierung nicht möglich ist, eine diesbezügliche Meldung sowie eine Information darüber, warum die Realisierung nicht möglich war, z.B. weil keine Verbindungsreserven mehr zur Verfügung standen.

Die im vorliegenden Fall als Ausführungsbeispiel gewählte Ampelsteuerung ist selbstverständlich nicht so zeitkritisch wie andere Steuerungsvorgänge. Sie wurde jedoch gewählt, da sich anhand dieses einfachen Beispiels die prinzipielle Vorgehensweise einfach erläutern läßt.

Im Ergebnis ergibt sich damit ein umfeldprogrammierbares Logikfeld, das zwar bei weitem nicht optimal ausgenutzt ist, dessen Programmierung aber schnell und einfach und vor allem in einer dem SPS-Anwender vertrauten Art und Weise erfolgt.

## Patentansprüche

1. Programmierverfahren zum rechnergesteuerten internen elektrischen Verbinden eines umfeldprogrammierbaren Logikfeldes, das aus einer mindestens zweidimensionalen Anordnung von Logikblöcken (31) besteht, die durch vom Anwender frei festlegbare interne elektrische Verbindungen miteinander und mit dem Umfeld verbindbar sind,
- wobei aus einem vorgegebenen funktionalen Gesamtverhalten, z.B. aufgrund eines vorgegebenen funktionalen Schaltplans, insbesondere eines Funktionsplans für eine speicherprogrammierbare Steuerung, interne elektrische Konfigurationen, also Verbindungen und gegebenenfalls auch Logikfunktionen, des Logikfeldes bestimmt werden, welche das vorgegebene funktionale Gesamtverhalten realisieren,
- wobei die so bestimmten internen elektrischen Konfigurationen, also Verbindungen und gegebenenfalls auch die Logikfunktionen, dem Logikfeld eingeprägt werden,
- wobei unabhängig von dem vorgegebenen funktionalen Gesamtverhalten beim Festlegen der internen elektrischen Verbindungen ein Teil der im Prinzip frei festlegbaren internen elektrischen Verbindungen fest vorgegeben wird, und
- wobei die Logikblöcke (31) durch den fest vorgegebenen Teil der internen elektrischen Verbindungen in Gruppen (36) aufgeteilt werden, die zumindest teilweise gleiche Konfigurationen aufweisen.

2. Verfahren nach Anspruch 1, **dadurch gekennzeichnet**, daß das vorgegebene funktionale Gesamtverhalten in Teilfunktionen (84-100) zerlegt wird, die zumindest teilweise in je einer Gruppe (36) von Logikblöcken (31) realisierbar sind.

3. Verfahren nach Anspruch 1 oder 2, **dadurch gekennzeichnet**, daß für Standard-Teilfunktionen (99, 100), insbesondere komplexe Standard-Teilfunktionen (99,100), interne elektrische Standard-Konfigurationen, also Verbindungen und gegebenenfalls auch Logikfunktionen, vorgebbar sind.

4. Verfahren nach Anspruch 3, **dadurch gekennzeichnet,** daß die Standard-Teilfunktionen (99,100) durch mehr als eine Gruppe (36) von Logikblöcke (31) realisierbar sind.

5. Verfahren nach Anspruch 2 oder 3, **dadurch gekennzeichnet,** daß Teilfunktionen (84-98) und Standard-Teilfunktionen (99,100), die in einer Gruppe (36) von Logikblöcken (31) realisierbar sind, zusammengefaßt werden, sofern auch die Zusammenfassung in einer Gruppe (36) von Logikblöcken (31) realisierbar ist.

6. Verfahren nach einem der Ansprüche 2 bis 5, **dadurch gekennzeichnet**, daß
- die Teilfunktionen (84-98) und/oder die Standard-Teilfunktionen (99,100) und/oder die Zusammenfassung den Gruppen (36) von Logikblöcken (31) zugeordnet werden,
- unter Berücksichtigung der fest vorgegebenen internen elektrischen Verbindungen die internen elektrischen Verbindungen ermittelt werden, die die Gruppen (36) von Logikblöcken (31) derart miteinander verschalten, daß das vorgegebene funktionale Gesamtverhalten realisiert wird,
- und die so ermittelten internen elektrischen Verbindungen dem Logikfeld eingeprägt werden, vorzugsweise zusammen mit den fest vorgegebenen internen elektrischen Verbindungen.

7. Verfahren nach Anspruch 6, **dadurch gekennzeichnet,** daß bei einem Logikfeld mit langreichweitigen Langverbindungen (32,33) und kurzreichweitigen Kurzverbindungen (35) die elektrischen Verbindungen zu Prozeßeingängen und Prozeßausgängen zumindest teilweise über die Langverbindungen (32,33) erfolgen.

8. Verfahren nach Anspruch 6 oder 7, **dadurch gekennzeichnet,** daß bei einem Logikfeld mit langreichweitigen Langverbindungen (32,33) und kurzreichweitigen Kurzverbindungen (35) die internen elektrischen Verbindungen soweit als möglich über die Kurzverbindungen (35) erfolgen und nur die über die Kurzverbindungen (35) nicht realisierbaren internen elektrischen Verbindungen über die Langverbindungen (32,33) erfolgen.

9. Verfahren nach Anspruch 8, **dadurch gekennzeichnet,** daß die Langverbindungen (32,33) teilweise unterbrechbar sind und daß die internen elektrischen Verbindungen erst dann über die nicht unterbrechbaren Langverbindungen (32,33) erfolgen, wenn die internen elektrischen Verbindungen über die unterbrechbaren Langverbindungen (32,33) nicht realisierbar sind.

10. Verfahren nach einem der Ansprüche 1 bis 9, **dadurch gekennzeichnet,** daß das funktionale Gesamtverhalten in einer Programmiersprache für speicherprogrammierbare Steuerungen vorgegeben wird.

11. Verfahren nach einem der Ansprüche 1 bis 10, **dadurch gekennzeichnet,** daß das funktionale Gesamtverhalten in einer graphischen Programmiersprache vorgegeben wird.

## Claims

1. A programming method for the computer-controlled internal electrical connection of a field-programmable gate array comprising an at least two-dimensional arrangement of logic blocks (31) which can be connected to one another and to the environment by means of internal electrical connections freely definable by the user
- wherein, from a predetermined overall functional performance characteristic, for example on the basis of a predetermined functional circuitry plan, in particular a function plan for a stored-program controller, internal electrical configurations, thus connections and optionally also logic functions, of the gate array which implement the predetermined overall functional performance characteristic are defined,
- wherein the thus defined internal electrical configurations, thus connections and optionally also logic functions, are impressed upon the gate array,
- wherein, independently of the predetermined overall functional performance characteristic, upon the establishment of the internal electrical connections a part of the fundamentally freely definable internal electrical connections is permanently specified and
- wherein the logic blocks (31) are divided into groups (36) by the permanently specified part of the internal electrical connections, which groups (36) at least in part have the same configurations.

2. A method according to Claim 1, characterised in that the predetermined overall functional performance characteristic is split into sub-functions (84-100) which at least in part can each be implemented in a group (36) of logic blocks (31).

3. A method according to Claim 1 or 2, characterised in that for standard sub-functions (99, 100), in particular complex standard sub-functions (99, 100), internal electrical standard configurations, thus connections and optionally also logic functions, can be specified.

4. A method according to Claim 3, characterised in that the standard sub-functions (99, 100) can be implemented by more than one group (36) of logic blocks (31).

5. A method according to Claim 2 or 3, characterised in that sub-functions (84-98) and standard sub-functions (99, 100) which can be implemented in a group (36) of logic blocks (31) are combined, provided the combination can also be implemented in a group (36) of logic blocks (31).

6. A method according to one of Claims 2 to 5, characterised in that
- the sub-functions (84-98) and/or the standard sub-functions (99, 100) and/or the combination are assigned to the groups (36) of logic blocks (31),
- taking into consideration the permanently specified internal electrical connections, the internal electrical connections which interconnect the groups (36) of logic blocks (31) to one another so as to implement the predetermined overall functional performance characteristic are determined,
- and the thus determined internal electrical connections are impressed upon the gate array, preferably together with the permanently specified internal electrical connections.

7. A method according to Claim 6, characterised in that in the case of a gate array with long-range long connections (32, 33) and short-range short connections (35), the electrical connections to process inputs and process outputs take place at least in part via the long connections (32, 33).

8. A method according to Claim 6 or 7, characterised in that in a gate array with long-range long connections (32, 33) and short-range short connections (35), the internal electrical connections take place as far as possible via the short-connections (35) and only those internal electrical connections which cannot be implemented via the short-connections (35) take place via the long connections (32, 33).

9. A method according to Claim 8, characterised in that the long connections (32, 33) are partially interruptible and that the internal electrical connections take place via the non-interruptible long connections (32, 33) only when the internal electrical connections cannot be implemented via the interruptible long connections (32, 33).

10. A method according to one of Claims 1 to 9, characterised in that the overall functional performance characteristic is specified in a programming language for stored program controllers.

11. A method according to one of Claims 1 to 10, characterised in that the overall functional performance characteristic is specified in a graphic programming language.

## Revendications

1. Procédé de programmation pour la liaison électrique interne, commandée par ordinateur, d'un circuit logique programmable par l'utilisateur qui consiste en un agencement au moins à deux dimensions de blocs logiques (31) qui peuvent être reliés entre eux et à la périphérie par des liaisons électriques internes pouvant être spécifiées librement par l'utilisateur,
dans lequel
- à partir d'un comportement fonctionnel global prescrit, par exemple sur la base d'un schéma fonctionnel de connexions prescrit, notamment d'un schéma logique pour une commande par programme enregistré, on détermine des configurations électriques internes du circuit logique, donc des liaisons et aussi éventuellement des fonctions logiques, qui mettent en oeuvre le comportement fonctionnel global prescrit,
- on imprime sur le circuit logique les configurations électriques internes ainsi déterminées, donc des liaisons et aussi éventuellement des fonctions logiques,
- une partie des liaisons électriques internes qui peuvent en principe être spécifiées librement étant prédéterminées, indépendamment du comportement fonctionnel global prescrit, lors de la spécification des liaisons électriques internes,
- les blocs logiques (31) étant répartis en groupes (36), qui ont au moins en partie de mêmes configurations, par la partie prédéterminée des liaisons électriques internes.

2. Procédé selon la revendication 1, caractérisé par le fait que l'on décompose le comportement fonctionnel global prescrit en fonctions partielles (84 à 100) qui peuvent être mises en oeuvre au moins en partie chacune dans un groupe (36) de blocs logiques (31).

3. Procédé selon la revendication 1 ou 2, caractérisé par le fait que, pour des fonctions partielles normalisées (99, 100), notamment des fonctions partielles normalisées complexes (99, 100), on peut prescrire des configurations électriques internes normalisées, donc des liaisons et aussi éventuellement des fonctions logiques normalisées.

4. Procédé selon la revendication 3, caractérisé par le fait que les fonctions partielles normalisées (99, 100) peuvent être mises en oeuvre par plus d'un groupe (36) de blocs logiques (31).

5. Procédé selon la revendication 2 ou 3, caractérisé par le fait l'on réunit des fonctions partielles (84 à 98) et des fonctions partielles normalisées (99, 100), qui peuvent être mises en oeuvre dans un groupe (36) de blocs logiques (31), dans la mesure ou la réunion peut être mise en oeuvre dans un groupe (36) de blocs logiques (31).

6. Procédé selon l'une des revendications 2 à 5, caractérisé par le fait que
- on associe les fonctions partielles (84 à 98) et/ou les fonctions partielles normalisées (99, 100) et/ou la réunion de fonctions aux groupes (36) de blocs logiques (31),
- en tenant compte des liaisons électriques internes prédéterminées, on détermine les liaisons électriques internes qui câblent les groupes (36) de blocs logiques (31) les uns aux autres de manière à mettre en oeuvre le comportement fonctionnel global prescrit, et
- on imprime sur le circuit logique les liaisons électriques internes ainsi déterminées, ce préférence en même temps que les liaisons électriques internes prédéterminées.

7. Procédé selon la revendication 6, caractérisé par le fait que, pour un circuit logique ayant des liaisons (32, 33) longues, c'est-à-dire couvrant une longue distance, et des liaisons (35) courtes, c'est-à-dire couvrant une courte distance, les liaisons électriques vers des entrées de processus et vers des sorties de processus s'effectuent au moins en partie par l'intermédiaire des liaisons longues (32, 33).

8. Procédé selon la revendication 6 ou 7, caractérisé par le fait que, pour un circuit logique ayant des liaisons (32, 33) longues, c'est-à-dire couvrant une longue distance, et des liaisons (35) courtes, c'est-à-dire couvrant une courte distance, les liaisons électriques internes s'effectuent dans la mesure du possible par l'intermédiaire des liaisons courtes (35) et seules les liaisons électriques internes ne pouvant pas être mises en oeuvre par l'intermédiaire des liaisons courtes (35) s'effectuent par l'intermédiaire des liaisons longues (32, 33).

9. Procédé selon la revendication 8, caractérisé par le fait qu'une partie des liaisons longues (32, 33) peuvent être coupées et que les liaisons électriques internes ne s'effectuent par l'intermédiaire des liaisons longues (32, 33) ne pouvant pas être coupées que si les liaisons électriques internes ne peuvent pas être mises en oeuvre par l'intermédiaire des liaisons longues (32, 33) pouvant être coupées.

10. Procédé selon l'une des revendications 1 à 9, caractérisé par le fait que l'on prescrit le comportement fonctionnel global dans un langage de programmation destiné à des commandes par programmes enregistrés.

11. Procédé selon l'une des revendications 1 à 10, caractérisé par le fait que l'on prescrit le comportement fonctionnel global dans un langage de programmation graphique.
